# EUROPEAN PATENT APPLICATION

(11) **EP 4 207 269 A1**
(43) Date of publication of application: **05.07.2023**
(21) Application number: 21871652.0
(22) Date of filing: 26.09.2021
(51) Int. Cl.: H01L 23/31, H01L 25/07, H01L 21/56

(54) **SEMICONDUCTOR ENCAPSULATION STRUCTURE AND MANUFACTURING METHOD THEREFOR, AND SEMICONDUCTOR DEVICE**

(30) Priority: 28.09.2020 CN 202011046780
(71) Applicant: Huawei Technologies Co., Ltd., Shenzhen, Guangdong 518129 (CN)
(72) Inventor: QIAO, Yunfei, Shenzhen, Guangdong 518129 (CN); WU, Fankun, Shenzhen, Guangdong 518129 (CN); WANG, Junhe, Shenzhen, Guangdong 518129 (CN)
(74) Representative: Epping - Hermann - Fischer
(86) International application number: PCT/CN2021/120800
(87) International publication number: WO 2022/063283

(57) **Abstract**

Embodiments of this application provide a semiconductor packaged structure, including a circuit board, a chip, a pin, and a plastic package body. The pin includes a connecting part and a pressfit, one end of the connecting part is welded to the circuit board, the other end is flush with a top surface of the plastic package body, the connecting part has a mounting hole, the pressfit is disposed in the mounting hole and is in an interference fit with the connecting part, the pressfit is exposed from the top surface of the plastic package body, and both the top surface of the plastic package body and an end face of the other end of the connecting part are rough ground surfaces. Alternatively, the pin includes a pressfit, the plastic package body is provided with a mounting hole that runs through a plastic package body, the pressfit is provided in the mounting hole, one end of the pressfit is welded to the circuit board, the other end is exposed from the top surface of the plastic package body, the mounting hole is filled with insulating resin, and the insulating resin is wrapped around the pressfit. The semiconductor packaged structure is a packaged structure in a plastic-packaged form and with a pin arranged at the top, and has advantages such as a short electrical path, a small parasitic parameter, flexible pin arrangement, high reliability, and good heat dissipation performance. Embodiments of this application further provide a manufacturing method for a semiconductor packaged structure.

## Description

This application claims priority to Chinese Patent Application No. 202011046780.5, filed with the China National Intellectual Property Administration on September 28, 2020 and entitled "SEMICONDUCTOR PACKAGED STRUCTURE AND MANUFACTURING METHOD THEREOF, AND SEMICONDUCTOR DEVICE", which is incorporated herein by reference in its entirety.

### TECHNICAL FIELD

This application relates to the field of semiconductor device technologies, and in particular, to a semiconductor packaged structure and a manufacturing method thereof, and a semiconductor device.

### BACKGROUND

Currently, there are mainly two types of power module packaged structures in the semiconductor packaging field: One type is a housing-type packaged structure with a pin (pin) arranged at the top. This type of packaged structure has advantages of a short electrical path, a small parasitic parameter, and high flexibility of pin arrangement because the pin is arranged at the top. However, a cavity in a housing of this structure is filled with silica gel, a heat dissipation capability of a module is poor, costs are high, and the pin is likely to be bent during assembly. The other type is a packaged structure in a plastic-packaged form and with a welded pressfit. This type of packaged structure has pins arranged on both sides, and has advantages of good heat-conducting property, high reliability, and high pin strength. However, because the pins are arranged on both sides, an electrical path is long, and a parasitic parameter is large. In addition, the pins need to be welded to a target circuit board of an application end, and are non-detachable. In view of this, a semiconductor packaged structure needs to be provided, to resolve a problem that an existing packaged structure cannot meet both requirements of top pin arrangement and high heat dissipation performance.

### SUMMARY

Embodiments of this application provide a semiconductor packaged structure and a manufacturing method thereof. The semiconductor packaged structure is a packaged structure in a plastic-packaged form and with a pin arranged at the top, and has advantages of a short electrical path, a small parasitic parameter, and flexible pin location arrangement. In addition, the semiconductor packaged structure has good heat dissipation performance, a simple packaging process, reliably connected components, and low costs.

A first aspect of embodiments of this application provides a semiconductor packaged structure, including: a circuit board, a chip and a pin that are disposed on the circuit board, and a plastic package body that covers the circuit board, the chip, and the pin.

The pin includes a connecting part and a pressfit, one end of the connecting part is welded to the circuit board, the other end is flush with a top surface of the plastic package body, the connecting part has a mounting hole, the pressfit is disposed in the mounting hole and is in an interference fit with the connecting part, one end of the pressfit is exposed from the top surface of the plastic package body, the top surface of the plastic package body is a rough ground surface, and an end face of the other end of the connecting part is a rough ground surface.

Alternatively, the pin includes a pressfit, the plastic package body is provided with a mounting hole that runs through a top surface of the plastic package body to the circuit board, the pressfit is disposed in the mounting hole, one end of the pressfit is welded to the circuit board, the other end is exposed from the top surface of the plastic package body, the mounting hole is filled with insulating resin, and the insulating resin is wrapped around the pressfit.

The semiconductor packaged structure in this embodiment of this application is a packaged structure in a plastic-packaged form and with a pin arranged at the top, and has advantages of a short electrical path and a small parasitic parameter, thereby facilitating signal transmission. In addition, a location of a pin may be flexibly arranged according to a requirement, and a quantity, namely, arrangement density, of pins may also be increased according to a requirement. In addition, the pin is not easily bent or deformed, thereby avoiding bending, collapsing and kneeling. The semiconductor packaged structure in this application further has good heat dissipation performance, can form a good heat dissipation channel, can dissipate heat generated inside a device to the outside in a timely manner, has high reliability, and is applicable to a high-power semiconductor device. In the semiconductor packaged structure, after the plastic package body is formed through injection molding, the plastic package body and the connecting part are ground to expose the mounting hole, and then the pressfit is mounted in the mounting hole through an interference fit, to implement a packaged structure in a plastic-packaged form and with a pin arranged at the top. Alternatively, after the plastic package body with the mounting hole is formed through injection molding by using a plastic packaging mold of a specific structure, the pressfit is welded in the mounting hole, and the mounting hole is filled with the insulating resin to implement a packaged structure in a plastic-packaged form and with a pin arranged at the top. An entire packaging process is simple, and costs are controllable.

In some implementations of this application, the connecting part includes an encircling side wall, and one end of the side wall (namely, the bottom of the side wall) of the connecting part is welded to the circuit board. A welding part is formed between the bottom of the side wall and the circuit board. The bottom of the side wall is an end, of the connecting part, that is connected to the circuit board. A thickness of the side wall of the connecting part may be set according to a through-current requirement of a device. If a through-current is large, the thickness of the side wall of the connecting part may be set to be large. If a through-current is small, the thickness of the side wall of the connecting part may be set to be small.

In other implementations of this application, the connecting part includes a base and an encircling side wall, and the base of the connecting part is welded to the circuit board. A welding part is formed between the base and the circuit board. A thickness of the side wall of the connecting part may be set according to a through-current requirement of a device. If a through-current is large, the thickness of the side wall of the connecting part may be set to be large. If a through-current is small, the thickness of the side wall of the connecting part may be set to be small.

In an implementation of this application, the connecting part is made of a conductive metal material. Specifically, the material may be a metal with good conductivity, for example, copper, silver, or aluminum.

In an implementation of this application, the connecting part includes a connecting part body and a surface layer disposed on a surface of the connecting part body, and the surface layer is an electroplated tin layer, an electroplated nickel layer, an electroless nickel immersion gold layer, or an electroless nickel electroless palladium immersion gold layer. By disposing the surface layer, welding performance of the connecting part can be improved, to better connect to the circuit board. In addition, the surface layer can further improve antioxidation performance of the connecting part.

In an implementation of this application, a length of a part, of the pressfit, that is located in the mounting hole of the connecting part is greater than or equal to 1/2 of a total length of the pressfit. This can ensure that a length of a part, of the pressfit, that is in an interference fit with the connecting part is greater than or equal to 1/2 of the total length of the pressfit, thereby improving reliability of a connection between the pressfit and the connecting part.

In an implementation of this application, a roughness Ra of the rough ground surface of the plastic package body is greater than 0.1 micrometer, and the roughness Ra of a rough ground surface of the connecting part is greater than 0.1 micrometer.

In an implementation of this application, the insulating resin includes epoxy resin. The epoxy resin has good insulation performance, and is easy to obtain.

In an implementation of this application, a filling height of the insulating resin is greater than or equal to 1/4 of the length of the pressfit. The insulating resin has a specific filling height and therefore can be better wrapped around the pressfit, thereby effectively ensuring structural stability of the pressfit.

In an implementation of this application, the pressfit is made of a conductive metal material. Specifically, the material may be a metal with good conductivity, for example, copper, silver, or aluminum. The pressfit may include a pressfit body and a protective layer disposed on a surface of the pressfit body. A material of the protective layer may be, for example, tin.

In an implementation of this application, the pin is a linear pin and does not have a bent part. The linear pin has a short electrical path and a small parasitic parameter, thereby facilitating signal transmission.

In an implementation of this application, the pin is a vertical pin, and the pin extends along a direction perpendicular to a surface of the circuit board. The vertical pin has a shortest electrical path and a smallest parasitic parameter, thereby facilitating signal transmission.

In an implementation of this application, the semiconductor packaged structure includes a plurality of pins, and the plurality of pins are spaced. In an implementation of this application, the plurality of pins are all vertical pins.

In an implementation of this application, the semiconductor packaged structure includes a plurality of chips, and the plurality of chips may have different functions.

In an implementation of this application, the semiconductor packaged structure further includes other electronic components disposed on the circuit board. The other electronic components may include but are not limited to a resistor, a capacitor, an inductor, a thermal sensing element, and the like. The other electronic components may alternatively be various packaged components.

According to a second aspect, an embodiment of this application provides a manufacturing method for a semiconductor packaged structure, including:
fastening a chip to a circuit board;
welding a connecting base to the circuit board, where the connecting base has a closed mounting hole; or the connecting base has a mounting hole that is open toward one end, and the mounting hole is closed after the welding;
bonding the chip to the circuit board through a metal wire;
performing, by using a plastic packaging material, plastic packaging on the circuit board provided with the chip and the connecting part, to form a plastic package body;
grinding a top surface of the plastic package body and the connecting base, so that the mounting hole is exposed, where after the grinding, the connecting base forms a connecting part, and a ground end of the connecting part is flush with the top surface of the plastic package body; and
mounting a pressfit in the mounting hole, where the pressfit and the connecting part are in an interference fit, one end of the pressfit is located in the mounting hole, and the other end is exposed from the mounting hole.

In the manufacturing method for a semiconductor packaged structure that is provided in the second aspect of embodiments of this application, a package in a plastic-packaged form and with a pin arranged at the top can be implemented. There is no special requirement for a shape of a plastic packaging mold, and a common plastic packaging mold can be used. The mold is easy to obtain, and semiconductor devices with different internal structures can be packaged. Therefore, the plastic packaging mold can be reused, thereby greatly reducing packaging costs. The packaging method is not limited by a product thickness either and is applicable to packaging of products with different thicknesses, and may be used to package a thick product with a thickness greater than 5 mm. When a plurality of pins need to be disposed, the method has no special requirement for flatness of a plurality of connecting bases, and a specific height difference is allowed between the plurality of connecting bases. Therefore, the packaging method is highly practical.

According to a third aspect, an embodiment of this application provides a manufacturing method for a semiconductor packaged structure, including:
fastening a chip to a circuit board, and bonding the chip to the circuit board through a metal wire;
performing, by using a plastic packaging mold and a plastic packaging material, plastic packaging on the circuit board to which the chip is fastened, to form a plastic package body, where the plastic packaging mold includes a first mold and a second mold that fit with each other, a protrusion structure corresponding to a location of a pre-arranged pin is disposed in the first mold, and after the plastic packaging, a mounting hole that runs through a top surface of the plastic package body to the circuit board is formed at the location of the pre-arranged pin in the plastic package body;
welding a pressfit in the mounting hole, where a welding part is formed between the pressfit and the circuit board, one end of the pressfit is located in the mounting hole, and the other end is exposed from the mounting hole; and
injecting insulating resin into the mounting hole, to obtain a semiconductor packaged structure after curing.

In the manufacturing method for a semiconductor packaged structure that is provided in the third aspect of embodiments of this application, a package in a plastic-packaged form and with a pin arranged at the top can be implemented. The mounting hole used for mounting the pin can be directly obtained through injection molding by using a designed plastic packaging mold of a specific shape and structure. A location of the pin can be flexibly arranged, and the pin is not pressed against by a plastic package material during plastic packaging, so that a stable structure can be maintained. In addition, a reliable connection to the circuit board is implemented through welding and wrapping of the insulating resin.

According to a fourth aspect, an embodiment of this application further provides a semiconductor device, including the semiconductor packaged structure according to the first aspect of embodiments of this application.

In addition, an embodiment of this application further provides an electronic device, and the electronic device includes the semiconductor device according to the fourth aspect of embodiments of this application. The electronic device may be a mobile phone, an iPad, a notebook computer, a desktop computer, an intelligent wearable device, a display, a server, an instrument, a meter, or other devices.

The semiconductor packaged structure provided in embodiments of this application is a packaged structure in a plastic-packaged form and with a pin arranged at the top, and has advantages such as a short electrical path, a small parasitic parameter, high flexibility of pin arrangement, good heat-conducting property, and high reliability. In addition, during further assembly of the semiconductor packaged structure, crimping assembly may be performed, without reflow soldering, thereby simplifying an assembly process of a semiconductor device and reducing costs. The semiconductor packaged structure has a simple packaging process, reliably connected components, and low costs, can be processed by using a common plastic packaging mold and plastic packaging process, and is suitable for large-scale industrial production.

### BRIEF DESCRIPTION OF DRAWINGS

FIG 1 is a schematic diagram of a semiconductor packaged structure according to an embodiment of this application;
FIG 2 is a schematic diagram of a semiconductor packaged structure according to another embodiment of this application;
FIG 3 is a schematic flowchart of a manufacturing method for a semiconductor packaged structure according to an embodiment of this application; and
FIG 4 is a schematic flowchart of a manufacturing method for a semiconductor packaged structure according to another embodiment of this application.

### DESCRIPTION OF EMBODIMENTS

The following describes embodiments of this application with reference to accompanying drawings in embodiments of this application.

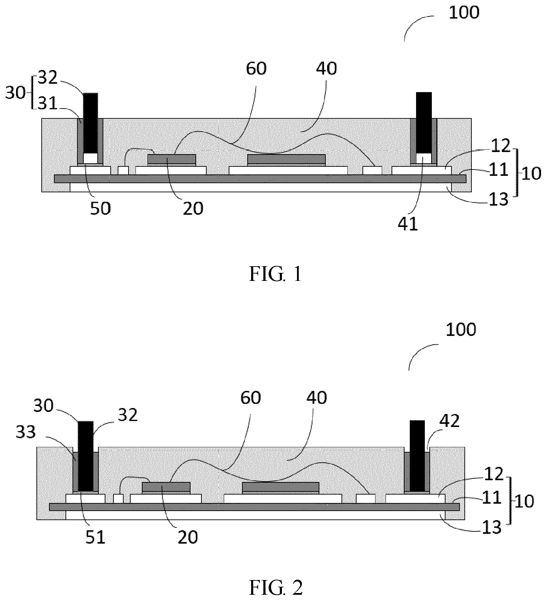

As shown in FIG 1 and FIG 2, an embodiment of this application provides a semiconductor packaged structure 100, including: a circuit board 10, a chip 20 and a pin 30 that are disposed on a surface of a side of the circuit board 10, and a plastic package body 40 that covers the circuit board 10, the chip 20, and the pin 30. The plastic package body 40 includes a bottom surface and a top surface that are opposite to each other. The bottom surface and the top surface are usually parallel to a surface of the circuit board 10. The top surface is a surface near a side, of the circuit board 10, on which the chip 20 is disposed, namely, a surface of a side above the chip. The bottom surface is a surface near a side, of the circuit board 10, on which no chip 20 is disposed. The pin 30 is exposed from the top surface of the plastic package body 40.

In an implementation of this application, as shown in FIG 1, the pin 30 includes a connecting part 31 and a pressfit 32. One end of the connecting part 31 is welded to the circuit board 10, and the other end (namely, an end away from the circuit board 10) extends along a direction away from the surface of the circuit board 10, and is flush with the top surface of the plastic package body 40. The connecting part 31 has a mounting hole 41, the pressfit 32 is disposed in the mounting hole 41 and is in an interference fit with the connecting part 31, and one end of the pressfit 32 is exposed from the top surface of the plastic package body 40. The plastic package body 40 is made of an abradable material. The top surface of the plastic package body 40 is a rough ground surface, and an end face of the other end of the connecting part 31 is a rough ground surface.

In this implementation, a specific shape and structure of the connecting part 31 are not limited. In some implementations of this application, the connecting part 31 has a through mounting hole 41, the connecting part 31 includes an encircling side wall, the bottom of the side wall of the connecting part 31 is welded to the circuit board 10, and a welding part 50 is formed between the bottom of the side wall and the circuit board 10 (as shown in FIG 1). In this case, the circuit board 10 or the welding part 50 formed on the circuit board 10 is at the bottom of the mounting hole 41. A top end face of the side wall of the connecting part 31 is the end face of the other end of the connecting part 31, and the top end face of the side wall of the connecting part 31 is flush with the top surface of the plastic package body 40, and is a rough ground surface.

In some other implementations of this application, the connecting part 31 includes a base and an encircling side wall that extends upward from the base. The base of the connecting part 31 is welded to the circuit board 10, and a welding part is formed between the base and the circuit board 10 through welding. In this case, the base of the connecting part 31 is at the bottom of the mounting hole 41. There is no special requirement for a thickness of the base.

In an implementation of this application, the connecting part 31 is made of a conductive metal material. In an implementation of this application, the pressfit 32 is made of a conductive metal material. Specifically, materials of the connecting part 31 and the pressfit 32 may be but are not limited to a metal with good conductivity, for example, copper, silver, or aluminum. In an implementation of this application, a specific shape of the connecting part 31 is not limited, and a cross-sectional shape of the connecting part 31 may be but is not limited to a regular shape such as a cylindrical shape, an elliptic cylindrical shape, a cuboid shape, or a polygonal shape, or certainly, may be an irregular shape. In an implementation of this application, the pressfit 32 may include a pressfit body and a protective layer disposed on a surface of the pressfit body. A material of the protective layer may be, for example, tin. For example, in a specific implementation of this application, the pressfit 32 is a copper pressfit with a tin-plated surface. In some implementations of this application, the pressfit 32 is flat, and different values may be selected for a thickness of the pressfit 32 according to a requirement. The thickness of the pressfit 32 may be, for example, 0.64 mm or 0.8 mm. A length of a part, of the pressfit 32, that is exposed from the top surface of the plastic package body 40 may be designed according to a requirement.

In an implementation of this application, a thickness of the side wall of the connecting part 31 may be specifically set according to a through-current requirement of a semiconductor device. If a large through-current is required, the thickness of the side wall of the connecting part 31 may be set to be large. If a small through-current is required, the thickness of the side wall of the connecting part 31 may be set to be small.

In an implementation of this application, the plastic package body 40 is made of an abradable material. The plastic package body 40 has abradability, and a thickness (height) of the plastic package body may be reduced through grinding, so that the connecting part 31 covered by the plastic package body is exposed. The connecting part 31 is made of an abradable metal, and a thickness (height) of the connecting part may be reduced through grinding. In an implementation of this application, the end face of the other end of the connecting part 31 and the top surface of the plastic package body 40 are both rough ground surfaces, and the end face of the other end of the connecting part 31 is flush with the top surface of the plastic package body 40. The rough ground surface is obtained through grinding, and a roughness of the rough ground surface is determined based on specifications of a grinding tool (for example, sandpaper). In some implementations, a roughness Ra of the rough ground surface of the top surface of the plastic package body 40 may be greater than 0.1 µm. In some other implementations, a roughness Ra of the rough ground surface of the top surface of the plastic package body 40 may be greater than or equal to 0.2 µm, specifically, for example, 0.2 µm to 0.3 µm. In some implementations, a roughness Ra of the rough ground surface of the end face of the other end of the connecting part 31 may be greater than 0.1 µm. In some other implementations, a roughness Ra of the rough ground surface of the end face of the other end of the connecting part 31 may be greater than or equal to 0.2 µm, specifically, for example, 0.2 µm to 0.3 µm.

In the semiconductor packaged structure 100 in this embodiment of this application, during plastic packaging, the pressfit has not been mounted, and the mounting hole is completely closed. Therefore, when plastic packaging adhesive is injected, the plastic packaging adhesive does not press against the pressfit to cause deformation of the pressfit, and the plastic packaging adhesive does not enter the mounting hole either. During mounting of the pressfit, adhesive removal does not need to be performed on the mounting hole. Therefore, in the semiconductor packaged structure in this embodiment of this application, a reliable connection of the pressfit is implemented, and a stable shape and structure of the pressfit can also be maintained, thereby avoiding problems such as bending.

In an implementation of this application, proper surface processing may be performed on the connecting part 31. After the surface processing, the connecting part 31 includes a connecting part body and a surface layer disposed on a surface of the connecting part body. The surface layer may be but is not limited to an electroplated tin layer, an electroplated nickel layer, an electroless nickel immersion gold layer, or an electroless nickel electroless palladium immersion gold layer. A thickness of the surface layer may be 0.03 µm to 25 µm. Specifically, in some implementations, the thickness of the surface layer is 0.1 µm to 20 µm. In some other implementations, the thickness of the surface layer is 0.5 µm to 15 µm. In some other implementations, the thickness of the surface layer is 1 µm to 5 µm. By disposing the surface layer, welding performance of the connecting part can be improved, to better connect to the circuit board. In addition, the surface layer can further improve antioxidation performance of the connecting part, and effectively prevent the connecting part from being oxidized in a packaging process and during storage in a regular environment. In addition, by disposing a surface layer with an appropriate thickness, both welding performance and antioxidation performance can be improved, without increasing plating costs of the surface layer. In this implementation, the pressfit 32 fits with the mounting hole 41 of the connecting part 31. As shown in FIG. 1, the pressfit 32 may not be inserted into the bottom of the mounting hole 41. To be specific, a specific distance or gap is reserved between an end, of the pressfit 32, that is located in the mounting hole 41 and the circuit board 10 or the base of the connecting part 31. Alternatively, the pressfit 32 may be inserted into the bottom of the mounting hole 41. To be specific, an end, of the pressfit 32, that is located in the mounting hole 41 abuts against the circuit board 10 or the welding part on the circuit board 10. To ensure mounting reliability of the pressfit 32 and implement a stable connection, in an implementation of this application, a length of a part, of the pressfit 32, that is located in the mounting hole 41 is greater than or equal to 1/2 of a total length of the pressfit 32. Therefore, a height (namely, a length) of the mounting hole 41 needs to be set to be greater than or equal to 1/2 of the total length of the pressfit 32. Specifically, in some implementations of this application, the length of the part, of the pressfit 32, that is located in the mounting hole 41 is 1/2 of the total length of the pressfit 32. In some other implementations of this application, the length of the part, of the pressfit 32, that is located in the mounting hole 41 is 2/3 of the total length of the pressfit 32. In some other implementations of this application, the length of the part, of the pressfit 32, that is located in the mounting hole 41 is 3/4 of the total length of the pressfit 32. It may be understood that a longer length of the part, of the pressfit 32, that is located in the mounting hole 41 indicates a larger contact surface between the pressfit 32 and the connecting part 31 that are in an interference fit. Therefore, a more stable and reliable connection can be implemented, to effectively prevent the pressfit 32 from falling off.

In another implementation of this application, as shown in FIG 2, the pin 30 includes a pressfit 32, the plastic package body 40 is provided with a mounting hole 42 that runs through the top surface of the plastic package body 40 to the circuit board 10, the pressfit 32 is disposed in the mounting hole 42, one end of the pressfit 32 is welded to the circuit board 10, to form a welding part 51 between the pressfit 32 and the circuit board 10, the other end is exposed from the top surface of the plastic package body 10, the mounting hole 42 is filled with insulating resin 33, and the insulating resin 33 is wrapped around the pressfit 32. In this implementation, the pressfit 32 is made of a conductive metal material. Specifically, a material of the pressfit 32 may be but is not limited to a metal with good conductivity, for example, copper, silver, or aluminum. In an implementation of this application, the pressfit 32 may include a pressfit body and a protective layer disposed on a surface of the pressfit body. A material of the protective layer may be, for example, tin. For example, in a specific implementation of this application, the pressfit 32 is a copper pressfit with a tin-plated surface. In some implementations of this application, the pressfit 32 is flat, and different values may be selected for a thickness of the pressfit 32 according to a requirement. The thickness of the pressfit 32 may be, for example, 0.64 mm or 0.8 mm. A length of a part, of the pressfit 32, that is exposed from the top surface of the plastic package body 40 may be designed according to a requirement.

In an implementation of this application, the mounting hole 42 is filled with the insulating resin 33. The insulating resin 33 can securely fasten the pressfit 32 to prevent the pressfit 32 from falling off, and can prevent the pressfit 32 from being damaged due to an external factor during subsequent use. In an implementation of this application, the insulating resin 33 includes but is not limited to epoxy resin. Specifically, the insulating resin 33 may be a resin composition including one or more types of epoxy resin. There are many types of epoxy resin, and the epoxy resin is highly available, thereby helping control packaging costs. In this application, the epoxy resin used to fill the mounting hole 42 is liquid-state epoxy resin.

In an implementation of this application, a filling height of the insulating resin 33 may be less than or equal to a height (namely, a length) of the mounting hole 42. To be specific, an upper surface of the insulating resin 33 may be lower than the top surface of the plastic package body 40, or may be flush with the top surface of the plastic package body 40. To provide more stable support for the pressfit 32, prevent the pressfit 32 from being bent and deformed, and improve connection reliability of the pressfit 32, the filling height of the insulating resin 33 in the mounting hole 42 is greater than or equal to 1/4 of a length of the pressfit. In addition, in some implementations of this application, the filling height of the insulating resin 33 is greater than or equal to 1/2 of the length of the pressfit. In some other implementations of this application, the filling height of the insulating resin 33 is greater than or equal to 2/3 of the length of the pressfit. In some other implementations of this application, the filling height of the insulating resin 33 is greater than or equal to 3/4 of the length of the pressfit. It may be understood that a greater filling height of the insulating resin 33 indicates better wrapping of the pressfit 32, and a more stable and reliable connection can be implemented, thereby effectively preventing the pressfit from falling off.

The semiconductor packaged structure 100 provided in this embodiment of this application is a structure with a pin (pin) arranged at the top. Compared with a structure with a pin (pin) arranged on a side in the conventional technology, the structure with a pin (pin) arranged at the top in this application has advantages of a short electrical path and a small parasitic parameter, thereby facilitating signal transmission. In addition, a location of pin may be flexibly arranged according to a requirement, and a quantity, namely, arrangement density, of pins may be increased according to a requirement. This increases design freedom of a product, and can adapt to a more complex internal circuit design, and implement a multi-functional pin layout. In the semiconductor packaged structure 100 in this embodiment of this application, it can be ensured that the pin is not easily bent or deformed, and the pressfit is protected from bending or collapsing. In addition, according to the semiconductor packaged structure 100 in this embodiment of this application, during further assembly of the semiconductor packaged structure 100, the entire semiconductor packaged structure 100 only needs to be crimped to a target circuit board for a mechanical connection through a surface on which the pressfit is disposed, without reflow soldering, thereby simplifying an assembly process of a semiconductor device and reducing costs. In addition, because the pin is stably and reliably connected in this application, the pin is not easily bent or deformed during crimping. The semiconductor packaged structure in this application is packaged by using the plastic package body. The plastic package body has good heat dissipation performance, can form a good heat dissipation channel, can dissipate heat generated inside a device to the outside in a timely manner, and is applicable to a high-power semiconductor device.

In an implementation of this application, the pin 30, namely, a pin, is a wire that is led out from an internal circuit of an integrated circuit and that is configured to connect to a peripheral circuit, and the pin forms an interface for connecting the chip to the outside. In an implementation of this application, the pin is electrically connected to the circuit board through welding. A connection surface between the pin and the circuit board is usually small. Connection strength can be improved through welding, to avoid a risk that the pin falls off. A specific welding manner of the pin is not limited, and may be welding by using solder paste, a solder pad, or laser.

In an implementation of this application, the pin 30 is a linear pin and does not have a bent part. The linear pin has a shortest electrical path and a smallest parasitic parameter, thereby facilitating signal transmission. In some implementations of this application, the pin 30 is a vertical pin. To be specific, the pin 30 extends along a direction perpendicular to the surface of the circuit board 10. When the pin includes a connecting base and a pressfit, a side wall of the connecting base is perpendicular to the surface of the circuit board, and the pressfit is also perpendicular to the surface of the circuit board. When the pin includes a pressfit, the pressfit is perpendicular to the surface of the circuit board. By disposing the pin as a vertical pin, a structure is more stable.

In an implementation of this application, the semiconductor packaged structure 100 may include a plurality of pins 30, and a specific quantity and distribution density of pins 30 may be designed according to a through-current requirement. The plurality of pins 30 are disposed on the circuit board 10 at intervals. In the plurality of pins 30, there is no special requirement for a spacing distance between pins. For example, the spacing distance may be greater than 0.8 mm.

In an implementation of this application, a material of the plastic package body 40 may be epoxy resin. Specifically, the material of the plastic package body 40 is solid-state epoxy resin, and is obtained by liquefying the solid-state epoxy resin and then performing injection molding. The plastic package body 40 has good heat dissipation performance, and can form a good heat dissipation channel. In addition, the plastic package body can provide mechanical support for electronic components such as the chip, and protect the electronic components such as the chip from external physical or chemical damage.

In an implementation of this application, as shown in FIG 1 and FIG 2, the semiconductor packaged structure 100 further includes a metal bonding wire 60. Electrical connections between the chip and the pin, and between chips may be implemented through the metal bonding wire 60.

In an implementation of this application, the circuit board 10 includes a first surface and a second surface that are opposite to each other. The chip 20, the pin 30, and the like are disposed on the first surface of the circuit board 10, that is, a surface of a side with a circuit pattern. The second surface (that is, on a side on which no chip 20 is disposed) of the circuit board 10 is exposed from the plastic package body 40. That is, the second surface of the circuit board 10 is not covered by the plastic package body 40, and is exposed from the plastic package body 40.

In an implementation of this application, as shown in FIG 1 and FIG 2, the circuit board 10 includes a substrate 11 and metal layers 12 and 13 disposed on the substrate. A material of the substrate 11 is not limited, and may be ceramic, organic resin, a metal frame, or the like. In a specific implementation of this application, the circuit board 11 is a double-sided copper clad ceramic substrate. The double-sided copper clad ceramic substrate includes a ceramic substrate and sintered copper plates disposed on two sides of the ceramic substrate. A copper plate on one side of the ceramic substrate is patterned to form a circuit pattern, and a side 12 on which the circuit pattern is formed is electrically connected to the chip 20. In an implementation of this application, the chip 20 may be electrically connected to the circuit board 10 in different manners. Specifically, for example, the chip is electrically connected to the circuit board through silver adhesive or welding. In the manner of electrically connecting the chip to the circuit board through welding, connection strength between the chip and the circuit board can be improved, and precision is high, thereby facilitating component connections after a device is miniaturized. The chip may be fastened to the circuit board through a surface mounting process and reflow soldering. A thickness of the circuit board may be selected according to an actual requirement. This is not particularly limited in this application.

In an implementation of this application, a heat dissipation component may be further disposed on the second surface of the circuit board 10, to implement a heat dissipation function. Specifically, the heat dissipation component may be but is not limited to a heat dissipation panel, a heat sink, or the like. The heat dissipation component may be connected to the second surface of the circuit board 10 through welding.

In an implementation of this application, the circuit board 10 serves as a carrying component to carry the chip 20, and is electrically connected to the chip 20 when carrying the chip 20. The chip 20 is disposed on the circuit board 10 and is stacked on the circuit board 10. In an implementation of this application, the chip 20 may be a chip with different functions, and may be specifically selected according to different function requirements. In some implementations, the chip 20 may be a power amplifier chip. In some other implementations, the chip 20 may be a radio frequency microwave and millimeter wave chip. In some other implementations, the chip 20 may alternatively be an insulated gate bipolar transistor (IGBT), or the like. In an implementation of this application, the semiconductor packaged structure 100 may include a plurality of chips 20 according to an actual function requirement. The plurality of chips may be chips with different functions.

In an implementation of this application, a front surface of the chip 20, that is, a surface away from the circuit board 10, is an active surface, and includes a functional transistor and a related circuit; and a rear surface, that is, a surface close to the circuit board 10, is a whole metal layer, and serves as a reference ground or a heat dissipation surface of the circuit. The metal layer may include a gold layer, a silver layer, a copper layer, or the like. The chip is electrically connected to the circuit board, and is electrically connected to a solder pad on the circuit board through the metal layer on the rear surface of the chip. The metal bonding wire connects a signal source on the front surface of the chip to a circuit wire on the circuit board.

In an implementation of this application, according to an actual function requirement, the semiconductor packaged structure 100 may further include other electronic component disposed on the circuit board 10. The other electronic components may include but are not limited to a resistor, a capacitor, an inductor, a thermal sensing element, and the like. The other electronic components may alternatively be various packaged components.

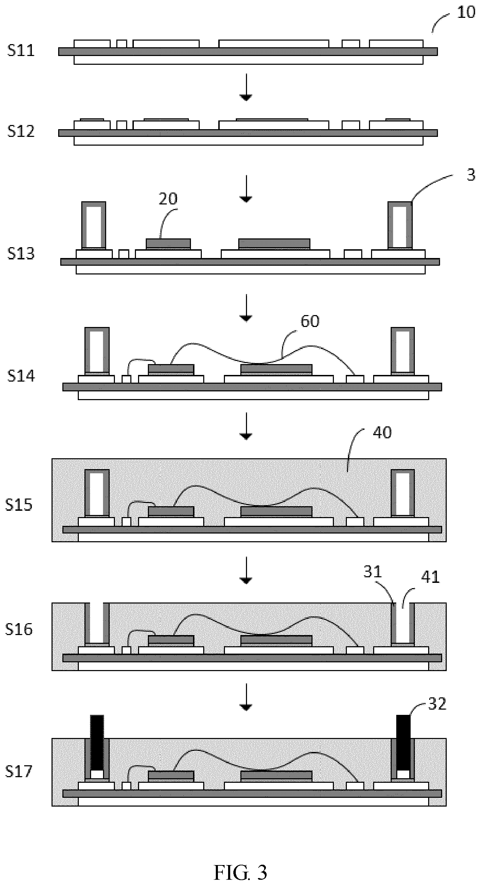

An embodiment of this application provides a manufacturing method for a semiconductor packaged structure. A schematic manufacturing flowchart is shown in FIG 3. The method includes the following steps.

S11: Provide a circuit board 10, where the circuit board may be a double-sided copper clad plate, the circuit board includes a first surface and a second surface that are opposite to each other, and a copper plate on the first surface is patterned to form a circuit pattern.

S12: Print the first surface of the circuit board by using solder paste, where a location of the solder paste printing may be determined according to locations of a chip, a pin, and other electronic components.

S13: Weld a chip 20 and a connecting base 3 to the first surface of the circuit board 10, where a material of the connecting base is a conductive metal, and may be but is not limited to a metal with good conductivity, for example, copper, silver, or aluminum.

In some implementations of this application, the connecting base 3 has a closed mounting hole, and includes a base and a top wall that are opposite to each other, and an encircling side wall. The base, the top wall, and the encircling side wall jointly form the closed mounting hole. The base of the connecting base 3 is welded to the circuit board 10. In some other implementations of this application, the connecting base 3 has a mounting hole that is open toward one end, and includes a top wall that is opposite and an encircling side wall. The top wall and the encircling side wall jointly form the mounting hole that is open toward one end. The bottom of the side wall (that is, a side of the opening) of the connecting base 3 is welded to the circuit board. After reflow soldering, the circuit board and the connecting base form a closed mounting hole, that is, the mounting hole, of the connecting base 3, that is open toward one end is closed after reflow soldering.

In an implementation of this application, a specific shape of the connecting base is not limited, and a cross-sectional shape of the connecting base may be but is not limited to a regular shape such as a cylindrical shape, an elliptic cylindrical shape, a cuboid shape, or a polygonal shape, or certainly, may be an irregular shape.

Certainly, in another implementation, the chip may alternatively be fastened to the circuit board without reflow soldering, for example, may be fastened through silver adhesive.

S14: Bond the chip to the circuit board through a metal wire, to form a metal bonding wire 60, when there are a plurality of chips, chips may also be bonded to each other through a metal wire. Bonding through the metal wire may be performed in a conventional manner in the art. Bonding through the metal wire can implement an electric connection between an internal chip, another electronic component, or the like and the circuit board or the pin.

S15: Perform, by using a plastic packaging material, plastic packaging on the circuit board provided with the chip and the connecting base, to form a plastic package body 40, where the plastic package body 40 completely covers the chip and the connecting base. The second surface of the circuit board is exposed from the plastic package body, that is, the second surface of the circuit board is flush with a bottom surface of the plastic package body. Usually, the plastic package body 40 exceeds an edge of the circuit board by a specific width, to better protect an internal electronic component and circuit covered by the plastic package body.

In an implementation of this application, a plastic packaging mold used during plastic packaging may be a common conventional plastic packaging mold, and the plastic packaging mold forms a plastic packaging cavity. A plastic packaging material in this application may be various plastic packaging materials commonly used in the semiconductor packaging field, for example, may be epoxy resin. Specifically, during plastic packaging, solid-state epoxy resin is liquefied, liquefied epoxy resin is injected into the plastic packaging cavity, and the plastic package body is obtained after the liquefied epoxy resin is cured.

S 16: Grind the top surface of the plastic package body 40 and the top wall of the connecting base, so that the closed mounting hole 41 of the connecting base is exposed. After the grinding, a thickness of the plastic package body 40 is reduced, and a rough ground surface is formed on the top surface, where a roughness Ra may be greater than 0.1 micrometer. The top wall of the connecting base 3 is removed through grinding, to form a connecting part 31. A rough ground surface is also formed at a ground end of the connecting part 31, where a roughness Ra may be greater than 0.1 micrometer. The ground end of the connecting part 31 is flush with the top surface of the plastic package body 40, that is, the rough ground surface of the connecting part 31 is flush with the rough ground surface of the plastic package body 40, thereby helping control implementation of a grinding operation, and also facilitating subsequent further assembly.

In an implementation of this application, a grinding tool such as sandpaper, a grinding wheel, or an automatic grinding machine may be used for grinding. Specifications and a grinding parameter of the grinding tool may be determined based on a thickness of a part, of the plastic package body, that is to be removed through grinding. For example, specifications of the sandpaper may be 400-grit, 800-grit, 1200-grit, or 2400-grit.

S17: Mount the pressfit 32 in the mounting hole 41, where the pressfit 32 and the connecting part 31 are in an interference fit, one end of the pressfit 32 is located in the mounting hole, and the other end is exposed from the mounting hole, that is, exposed from the top surface of the plastic package body 40, to obtain a semiconductor packaged structure.

The semiconductor packaged structure shown in FIG 1 in this embodiment of this application may be prepared with reference to the manufacturing method in S11 to S 17. The manufacturing method has a low requirement on a plastic packaging mold, and a common plastic packaging mold in the field may be used, so that costs are low. In addition, a packaged structure in a plastic-packaged form and with a pin arranged at the top can be implemented, an electrical path of the pin is short, a parasitic parameter is small, and good heat dissipation performance can be achieved. In addition, the pin is not easily bent or deformed.

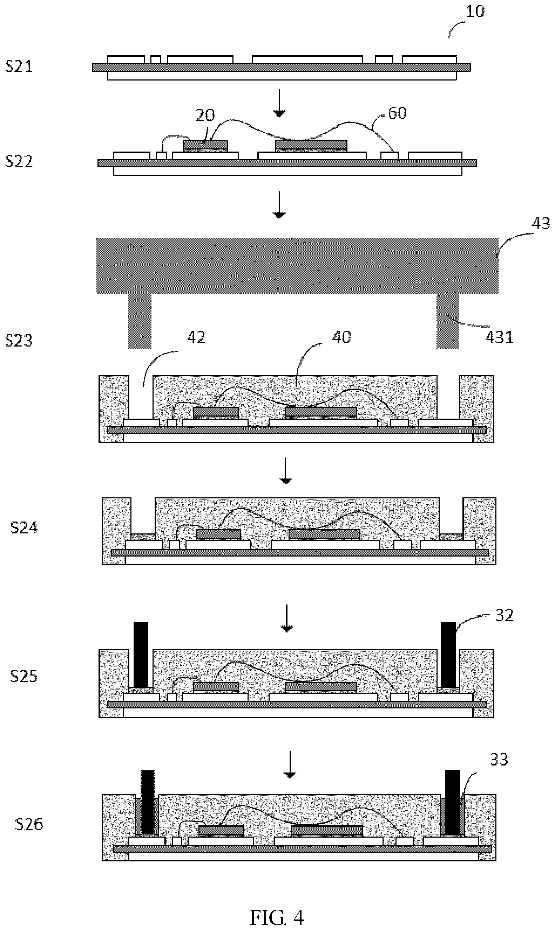

An embodiment of this application further provides a manufacturing method for a semiconductor packaged structure. A schematic manufacturing flowchart is shown in FIG 4. The method includes the following steps.

S21: Provide a circuit board 10, where the circuit board may be a double-sided copper clad plate, the circuit board includes a first surface and a second surface that are opposite to each other, and a copper plate on the first surface is patterned to form a circuit pattern; and
print the first surface of the circuit board by using solder paste, weld the chip 20 to the first surface of the circuit board 10, and then bond the chip to the circuit board through a metal wire.

S22: Perform, by using a plastic packaging mold and a plastic packaging material, plastic packaging on the circuit board to which the chip is fastened, to form a plastic package body 40.

The plastic packaging mold includes a first mold 43 and a second mold (not shown in the figure) that fit with each other. A protrusion structure 431 corresponding to a location of a pre-arranged pin is disposed in the first mold 43. After the plastic packaging, a mounting hole 42 that runs through a top surface of the plastic package body to the circuit board is formed at the location of the pre-arranged pin in the plastic package body 40. A size of the protrusion structure is the same as that of the mounting hole.

In an implementation of this application, the first mold 43 is connected to and fits with the second mold to form an injection molding cavity, and a size and a shape of the injection molding cavity determine a size and a shape of a finally molded plastic package body. Usually, an adhesive injection opening is provided on the first mold, and a plastic packaging material is injected through the adhesive injection opening. The plastic packaging material may be various plastic packaging materials commonly used in the semiconductor packaging field, for example, may be epoxy resin. Specifically, during plastic packaging, solid-state epoxy resin is liquefied, liquefied epoxy resin is injected into the plastic packaging cavity, and the plastic package body is obtained after the liquefied epoxy resin is cured.

S23: Apply solder paste in the mounting hole 42.

S24: Weld a pressfit 32 in the mounting hole 42, where a welding part is formed between the pressfit and the circuit board, one end of the pressfit is located in the mounting hole, and the other end is exposed from the mounting hole, that is, exposed from the top surface of the plastic package body 40.

S25: Inject insulating resin 33 into the mounting hole, to obtain a semiconductor packaged structure after curing.

Specifically, the insulating resin may be but is not limited to epoxy resin. The insulating resin may fully fill the mounting hole, or may partially fill the mounting hole. To be specific, an upper surface of the insulating resin may be flush with the top surface of the plastic package body 40, or may be lower than the top surface of the plastic package body 40. In this application, the epoxy resin used to fill the mounting hole is liquid-state epoxy resin, and the epoxy resin used to form the plastic package body 40 through injection molding is solid-state epoxy resin. The two types of epoxy resin are epoxy resin of different systems. A clear boundary may be formed after the two types of epoxy resin are molded.

The semiconductor packaged structure shown in FIG 2 in this embodiment of this application may be prepared by using the manufacturing method in S21 to S25. In the manufacturing method, a package in a plastic-packaged form and with a pin arranged at the top can be implemented. The mounting hole used for mounting the pin can be directly obtained through injection molding by using a designed plastic packaging mold of a specific shape and structure. A location of the pin can be flexibly arranged, and the pin is not pressed against by a plastic package material during plastic packaging, so that a stable structure can be maintained. In addition, a reliable connection to the circuit board is implemented through welding and wrapping of the insulating resin.

An embodiment of this application further provides a semiconductor device, including the foregoing semiconductor packaged structure in embodiments of this application. The semiconductor device may be a power semiconductor device, namely, a power electronic device (PED), and is a high-power electronic device (usually, a current is tens to thousands of ampersands, and a voltage is hundreds of volts) used for power conversion and a control circuit of a power device.

An embodiment of this application further provides an electronic device, including the foregoing semiconductor device in embodiments of this application. The electronic device may include a notebook computer, a tablet computer (iPad), a desktop computer, a server, a display, and various peripherals in the computer field; or may include a mobile phone, a telephone, and various other terminals and central office devices in the network communication field; or may include an intelligent wearable device, a conventional black or white appliance, and various digital products in the consumer electronics field; or may include an industrial personal computer, an automobile, various instruments and meters, a control device, and the like in the industrial control field.

## Claims

1. A semiconductor packaged structure, comprising: a circuit board, a chip and a pin that are disposed on the circuit board, and a plastic package body that covers the circuit board, the chip, and the pin, wherein
the pin comprises a connecting part and a pressfit, one end of the connecting part is welded to the circuit board, the other end is flush with a top surface of the plastic package body, the connecting part has a mounting hole, the pressfit is disposed in the mounting hole and is in an interference fit with the connecting part, one end of the pressfit is exposed from the top surface of the plastic package body, the top surface of the plastic package body is a rough ground surface, and an end face of the other end of the connecting part is a rough ground surface; or
the pin comprises a pressfit, the plastic package body is provided with a mounting hole that runs through a top surface of the plastic package body to the circuit board, the pressfit is disposed in the mounting hole, one end of the pressfit is welded to the circuit board, the other end is exposed from the top surface of the plastic package body, the mounting hole is filled with insulating resin, and the insulating resin is wrapped around the pressfit.

2. The semiconductor packaged structure according to claim 1, wherein the connecting part comprises an encircling side wall, and one end of the side wall of the connecting part is welded to the circuit board.

3. The semiconductor packaged structure according to claim 1, wherein the connecting part comprises a base and an encircling side wall, and the base of the connecting part is welded to the circuit board.

4. The semiconductor packaged structure according to any one of claims 1 to 3, wherein the connecting part is made of a conductive metal material.

5. The semiconductor packaged structure according to any one of claims 1 to 4, wherein the connecting part comprises a connecting part body and a surface layer disposed on a surface of the connecting part body, and the surface layer is an electroplated tin layer, an electroplated nickel layer, an electroless nickel immersion gold layer, or an electroless nickel electroless palladium immersion gold layer.

6. The semiconductor packaged structure according to any one of claims 1 to 5, wherein a length of a part, of the pressfit, that is located in the mounting hole of the connecting part is greater than or equal to 1/2 of a total length of the pressfit.

7. The semiconductor packaged structure according to any one of claims 1 to 6, wherein a roughness Ra of the rough ground surface of the plastic package body is greater than 0.1 micrometer, and a roughness Ra of the rough ground surface of the connecting part is greater than 0.1 micrometer.

8. The semiconductor packaged structure according to claim 1, wherein the insulating resin comprises epoxy resin.

9. The semiconductor packaged structure according to claim 1 or 8, wherein a filling height of the insulating resin is greater than or equal to 1/4 of the length of the pressfit.

10. The semiconductor packaged structure according to any one of claims 1 to 9, wherein the pressfit is made of a conductive metal material.

11. The semiconductor packaged structure according to any one of claims 1 to 10, wherein the pin is a linear pin and does not have a bent part.

12. The semiconductor packaged structure according to claim 11, wherein the pin is a vertical pin, and the pin extends along a direction perpendicular to a surface of the circuit board.

13. The semiconductor packaged structure according to any one of claims 1 to 12, wherein the semiconductor packaged structure comprises a plurality of pins, and the plurality of pins are spaced.

14. The semiconductor packaged structure according to any one of claims 1 to 13, wherein the semiconductor packaged structure further comprises other electronic components disposed on the circuit board.

15. A manufacturing method for a semiconductor packaged structure, comprising:
fastening a chip to a circuit board;
welding a connecting base to the circuit board, wherein the connecting base has a closed mounting hole; or the connecting part has a mounting hole that is open toward one end, and the mounting hole is closed after the welding;
bonding the chip to the circuit board through a metal wire;
performing, by using a plastic packaging material, plastic packaging on the circuit board provided with the chip and the connecting base, to form a plastic package body;
grinding a top surface of the plastic package body and the connecting base, so that the mounting hole is exposed, wherein after the grinding, the connecting base forms a connecting part, and a ground end of the connecting part is flush with the top surface of the plastic package body; and
mounting a pressfit in the mounting hole, wherein the pressfit and the connecting part are in an interference fit, one end of the pressfit is located in the mounting hole, and the other end is exposed from the mounting hole.

16. A manufacturing method for a semiconductor packaged structure, comprising:
fastening a chip to a circuit board, and bonding the chip to the circuit board through a metal wire;
performing, by using a plastic packaging mold and a plastic packaging material, plastic packaging on the circuit board to which the chip is fastened, to form a plastic package body, wherein the plastic packaging mold comprises a first mold and a second mold, a protrusion structure corresponding to a location of a pre-arranged pin is disposed in the first mold, and after the plastic packaging, a mounting hole that runs through a top surface of the plastic package body to the circuit board is formed at the location of the pre-arranged pin in the plastic package body;
welding a pressfit in the mounting hole, wherein a welding part is formed between the pressfit and the circuit board, one end of the pressfit is located in the mounting hole, and the other end is exposed from the mounting hole; and
injecting insulating resin into the mounting hole, to obtain a semiconductor packaged structure after curing.

17. A semiconductor device, comprising the semiconductor packaged structure according to any one of claims 1 to 14.

18. An electronic device, comprising the semiconductor device according to claim 17.
